(19) Europäisches Patentamt
European Patent Office
Office européen des brevets

(11) **EP 3 391 407 B1**

(12) **FASCICULE DE BREVET EUROPEEN**

(45) Date de publication et mention
de la délivrance du brevet:
**15.01.2020 Bulletin 2020/03**

(21) Numéro de dépôt: **16826379.6**

(22) Date de dépôt: **14.12.2016**

(51) Int Cl.:
**H01L 21/20** *(2006.01)*          **H01L 21/30** *(2006.01)*

(86) Numéro de dépôt international:
**PCT/FR2016/053440**

(87) Numéro de publication internationale:
**WO 2017/103487 (22.06.2017 Gazette 2017/25)**

(54) **COMPENSATION D'UNE COURBURE D'ARC GENEREE DANS UNE TRANCHE**

KOMPENSATION EINER LICHTBOGENKRÜMMUNG IN EINEM WAFER

COMPENSATION OF AN ARC CURVATURE GENERATED IN A WAFER

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **15.12.2015 FR 1562359**

(43) Date de publication de la demande:
**24.10.2018 Bulletin 2018/43**

(73) Titulaire: **Commissariat à l'Énergie Atomique
et aux Énergies Alternatives
75015 Paris (FR)**

(72) Inventeurs:
• **AIT-MANI, Abdenacer**
**38120 Saint-Egrève (FR)**
• **CHAMBION, Bertrand**
**38530 Pontcharra (FR)**

(74) Mandataire: **Talbot, Alexandre
Cabinet Hecké
28 Cours Jean Jaurès
38000 Grenoble (FR)**

(56) Documents cités:
**WO-A1-2010/102686      JP-A- S56 140 631
US-A1- 2007 292 987**

## Description

### Domaine technique

La présente invention a trait à un procédé et à une structure de compensation d'une courbure d'arc (également dénommée « flèche », et « bow » en langue anglaise) générée dans une tranche (« wafer » en langue anglaise) d'un matériau, notamment de type semi-conducteur.

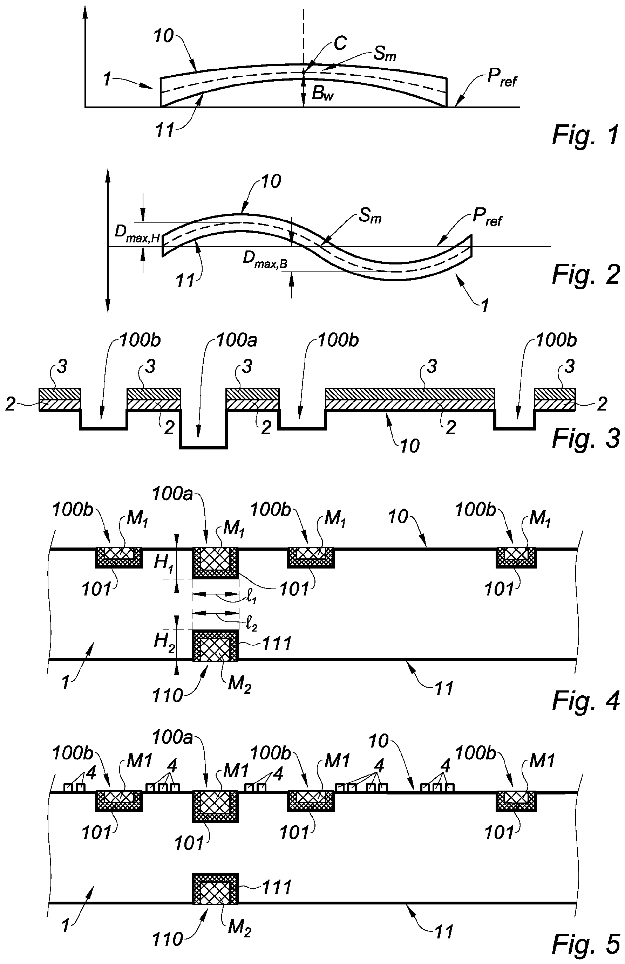

La courbure d'arc a été définie dans la norme ASTM F534, § 3.1.2. Comme illustré à la figure 1, une tranche 1 présente :

- une surface avant 10, et une surface arrière 11 opposée ;
- une surface médiane $S_m$ définie comme l'ensemble de points équidistants des surfaces avant et arrière 10, 11 lorsque la tranche 1 est libre de tout serrage.

La courbure d'arc $B_w$ est la distance entre le centre C de la surface médiane $S_m$ et un plan de référence $P_{ref}$. Le plan de référence $P_{ref}$ est défini par trois points répartis uniformément autour d'un cercle d'un diamètre inférieur au diamètre nominal de la tranche 1. La courbure d'arc $B_w$ est positive ou négative selon que le centre C est au-dessus ou au-dessous du plan de référence $P_{ref}$.

Une courbure d'arc peut être générée lorsqu'une couche est formée sur la tranche à une température donnée, la couche possédant un coefficient de dilatation thermique, dit CTE (acronyme pour *Coefficient of Thermal Expansion* en langue anglaise), très supérieur -ou très inférieur- à celui de la tranche à la température donnée. Cet effet est appelé effet bilame.

A titre d'exemple non limitatif, une application envisagée est l'épitaxie de GaN sur une tranche de silicium à 1050°C pour la fabrication de diodes électroluminescentes. Lorsque la tranche présente un diamètre de 200 mm, l'homme du métier vise préférentiellement l'obtention d'une courbure d'arc inférieure à 200 $\mu$m en valeur absolue. Une courbure d'arc supérieure à 200 $\mu$m est susceptible d'occasionner des défauts, tels que des fissures ou des délaminations, et sont préjudiciables pour des étapes ultérieures e.g. une photolithographie, une manipulation robotisée de la tranche etc.

### Etat de la technique antérieure

Pour compenser la courbure d'arc, il est connu de l'état de la technique de former deux couches métalliques (ou deux couches diélectriques) aux surfaces avant et arrière de la tranche. Ce procédé est en particulier connu pour des applications de report de composants de puissance.

Il est également connu de l'état de la technique, notamment du document JP 2002134451, de former des tranchées, non remplies, à la surface avant de la tranche pour compenser le voilage (« warp » en langue anglaise) de la tranche. Les tranchées sont formées avant le meulage (« grinding » en langue anglaise) de la surface arrière de la tranche. Les tranchées dessinent un chemin de découpe de la tranche.

Il est à noter que le voilage diffère de la courbure d'arc définie précédemment. Le voilage a été défini dans la norme ASTM F1390. Comme illustré à la figure 2, une tranche 1 présente :

- une surface avant 10, et une surface arrière 11 opposée ;
- une surface médiane $S_m$ définie comme l'ensemble de points équidistants des surfaces avant et arrière 10, 11 lorsque la tranche 1 est libre de tout serrage.

Il existe également un plan de référence $P_{ref}$ défini par trois points répartis uniformément autour d'un cercle d'un diamètre inférieur au diamètre nominal de la tranche 1.

Le voilage $W_p$ est défini par la relation $W_p = D_{max,H} - D_{max,B}$ où :

- $D_{max,H}$ est la distance maximale entre la surface médiane $S_m$ et le plan de référence, prise au-dessus du plan de référence $P_{ref}$ ;
- $D_{max,B}$ est la distance maximale entre la surface médiane $S_m$ et le plan de référence, prise au-dessous du plan de référence $P_{ref}$.

Le voilage $W_p$ est toujours un nombre positif dans la mesure où $D_{max, B}$ est un nombre négatif par définition et mode de calcul.

Les documents JP 56 140 631 et WO 2010/102 686 décrivent également des procédés de réduction du voilage de tranches.

De tels procédés de l'état de la technique ne sont pas entièrement satisfaisants dans la mesure où ils ne permettent pas d'assurer une courbure d'arc suffisamment faible de la tranche (par exemple inférieure à 200 $\mu$m en valeur absolue pour un diamètre de tranche de 200 mm) lors de la formation d'une couche à haute température (par exemple de l'ordre de 1000°C).

### Exposé de l'invention

Ainsi, la présente invention vise à remédier en tout ou partie aux inconvénients précités, et concerne à cet effet un procédé de compensation d'une courbure d'arc générée dans une tranche d'un matériau, la tranche comportant des première et seconde surfaces opposées, le matériau de la tranche possédant un coefficient de dilatation thermique, dit CTE et noté ao ; le procédé comportant les étapes :

a) former un ensemble de premières tranchées à la première surface de la tranche ;
b) former un ensemble de deuxièmes tranchées à la seconde surface de la tranche, au moins partiellement en regard des premières tranchées ;

c) remplir les premières tranchées d'un premier matériau possédant un CTE $\alpha_1$ ;

d) remplir les deuxièmes tranchées d'un deuxième matériau possédant un CTE $\alpha_2$, et vérifiant $\alpha_2 > \alpha_0$ lorsque le premier matériau vérifie $\alpha_1 > \alpha_0$ ou $\alpha_2 < \alpha_0$ lorsque le premier matériau vérifie $\alpha_1 < \alpha_0$.

Ainsi, un tel procédé selon l'invention permet de compenser une courbure d'arc par anticipation, c'est-à-dire avant une étape génératrice de la courbure d'arc, telle qu'une formation d'une couche à la première surface de la tranche à haute température.

Pour ce faire, les premières tranchées sont remplies d'un premier matériau différent du matériau de la tranche ($\alpha_1 \neq \alpha_0$), et des deuxièmes tranchées sont formées totalement en regard des premières tranchées, préférentiellement selon une symétrie par rapport au plan médian longitudinal de la tranche. Les deuxièmes tranchées sont remplies d'un deuxième matériau, pouvant être identique au premier matériau ($\alpha_1 = \alpha_2$). Le choix de $\alpha_2$ est tel que :

$$\alpha_2 > \alpha_0 \text{ si } \alpha_1 > \alpha_0,$$

$$\alpha_2 < \alpha_0 \text{ si } \alpha_1 < \alpha_0,$$

et ce afin d'obtenir une compensation de la courbure d'arc.

Le premier matériau -dit de remplissage- peut comporter un ensemble de N couches (N étant un entier naturel supérieur ou égal à 2) de matériaux différents remplissant les premières tranchées. Dans ce cas, le CTE du premier matériau $\alpha_1$ est calculé de la manière suivante :

$$\alpha_1 = \sum_{i=1}^{N} \alpha_{1i} \, v_i$$

où :

- $\alpha_{1i}$ est le CTE du matériau de la i-ème couche,
- $v_i$ est la fraction volumique du matériau de la i-ème couche au sein des premières tranchées.

De la même façon, le deuxième matériau -dit de remplissage- peut comporter un ensemble de N couches (N étant un entier naturel supérieur ou égal à 2) de matériaux différents remplissant les deuxièmes tranchées. Dans ce cas, le CTE du deuxième matériau $\alpha_2$ est calculé de la manière suivante :

$$\alpha_2 = \sum_{i=1}^{N} \alpha_{2i} \, v_i$$

où :

- $\alpha_{2i}$ est le CTE du matériau de la i-ème couche,
- $v_i$ est la fraction volumique du matériau de la i-ème couche au sein des deuxièmes tranchées.

Avantageusement, les premier et deuxième matériaux occupent respectivement un premier volume $V_1$ et un deuxième volume $V_2$ au sein des premières et deuxièmes tranchées à l'issue des étapes c) et d) ; et l'étape d) est exécutée de sorte que $V_2 = V_1 \times \dfrac{|\alpha_0 - \alpha_1|}{|\alpha_0 - \alpha_2|}$.

Ainsi, de tels volumes de remplissage permettent d'améliorer la compensation de la courbure d'arc.

Avantageusement, les premières et deuxièmes tranchées présentent respectivement un premier facteur de forme $\Phi_1$ et un deuxième facteur de forme $\Phi_2$ lors des étapes a) et b), définis comme le rapport entre la largeur et la profondeur des tranchées correspondantes ; et l'étape b) est exécutée de sorte que $\Phi_2 = \Phi_1 \pm 20\%$, de préférence $\Phi_2 = \Phi_1 \pm 15\%$, plus préférentiellement $\Phi_2 = \Phi_1 \pm 10\%$.

Ainsi, de tels facteurs de forme permettent d'améliorer la compensation de la courbure d'arc.

L'étape a) est exécutée de sorte que les premières tranchées dessinent un chemin de découpe de la tranche, et l'étape b) est exécutée de sorte que les deuxièmes tranchées sont totalement en regard des premières tranchées.

Ainsi, il est possible de valoriser le chemin de découpe afin de compenser la courbure d'arc.

Avantageusement, le procédé comporte une étape $a_1$) consistant à revêtir les premières tranchées d'une couche diélectrique avant l'étape c), la couche diélectrique étant préférentiellement une couche d'oxyde.

Ainsi, une telle couche diélectrique permet d'isoler électriquement les premières tranchées de la tranche.

Avantageusement, le procédé comporte une étape $b_1$) consistant à revêtir les deuxièmes tranchées d'une couche diélectrique avant l'étape d), la couche diélectrique étant préférentiellement une couche d'oxyde.

Ainsi, une telle couche diélectrique permet d'isoler électriquement les deuxièmes tranchées de la tranche.

Avantageusement, les étapes $a_1$) et $b_1$) sont concomitantes.

Ainsi, le temps d'opération du procédé est réduit.

Avantageusement, l'étape d) est exécutée de sorte que le deuxième matériau est identique au premier matériau, les étapes c) et d) étant de préférence concomitantes.

Ainsi, la mise en œuvre du procédé est simplifiée et le temps d'opération est fortement réduit. Les étapes c) et d) sont par exemple concomitantes lorsque les premier et deuxième matériaux sont des oxydes thermiques.

Avantageusement, le procédé comporte :

- une étape $c_1$) consistant à aplanir le premier matériau de manière à affleurer la première surface après l'étape c) ; et de préférence
- une étape $d_1$) consistant à aplanir le deuxième matériau de manière à affleurer la seconde surface après l'étape d).

Ainsi, la présence du premier matériau est évitée hors des premières tranchées, notamment à la première surface de la tranche, dans des zones actives pour de futurs composants.

Les étapes $c_1$) et $d_1$) sont préférentiellement exécutées par un polissage mécano-chimique.

Préférentiellement, les premier et deuxième matériaux sont sélectionnés dans le groupe comportant le silicium polycristallin, un polyimide, un polyépoxyde, un acrylique, un oxyde, un nitrure, un verre.

Préférentiellement, le matériau de la tranche est sélectionné dans le groupe comportant un matériau semi-conducteur, une céramique, un verre, le saphir; le matériau semi-conducteur étant de préférence à base de silicium.

La présente invention concerne également une structure de compensation d'une courbure d'arc, comportant :

- une tranche d'un matériau, comprenant des première et seconde surfaces opposées, le matériau de la tranche possédant un coefficient de dilatation thermique, dit CTE et noté $\alpha_0$ ;
- un ensemble de premières tranchées formées à la première surface, et remplies d'un premier matériau possédant un CTE $\alpha_1$ ;
- un ensemble de deuxièmes tranchées formées à la seconde surface, au moins partiellement en regard des premières tranchées, et remplies d'un deuxième matériau possédant un CTE $\alpha_2$, et vérifiant $\alpha_2 > \alpha_0$ ou $\alpha_2 < \alpha_0$ selon que le premier matériau vérifie $\alpha_1 > \alpha_0$ ou $\alpha_1 < \alpha_0$.

Ainsi, une telle structure selon l'invention permet de compenser une courbure d'arc par anticipation, c'est-à-dire avant une étape génératrice de la courbure d'arc, telle qu'une formation d'une couche à la première surface de la tranche à haute température.

Pour ce faire, les premières tranchées sont remplies d'un premier matériau différent du matériau de la tranche ($\alpha_1 \neq \alpha_0$) et des deuxièmes tranchées sont formées totalement en regard des premières tranchées, préférentiellement selon une symétrie axiale. Les deuxièmes tranchées sont remplies d'un deuxième matériau, pouvant être identique au premier matériau ($\alpha_1 = \alpha_2$). Le choix de $\alpha_2$ est tel que :

$$\alpha_2 > \alpha_0 \text{ si } \alpha_1 > \alpha_0,$$

$$\alpha_2 < \alpha_0 \text{ si } \alpha_1 < \alpha_0,$$

et ce afin d'obtenir une compensation de la courbure d'arc.

Les premières tranchées dessinent un chemin de découpe de la tranche.

Le premier matériau -dit de remplissage- peut comporter un ensemble de N couches (N étant un entier naturel supérieur ou égal à 2) de matériaux différents remplissant les premières tranchées. Dans ce cas, le CTE du premier matériau $\alpha_1$ est calculé de la manière suivante :

$$\alpha_1 = \sum_{i=1}^{N} \alpha_{1i} \, v_i$$

où :

- $\alpha_{1i}$ est le CTE du matériau de la i-ème couche,
- $v_i$ est la fraction volumique du matériau de la i-ème couche au sein des premières tranchées.

De la même façon, le deuxième matériau -dit de remplissage- peut comporter un ensemble de N couches (N étant un entier naturel supérieur ou égal à 2) de matériaux différents remplissant les deuxièmes tranchées. Dans ce cas, le CTE du deuxième matériau $\alpha_2$ est calculé de la manière suivante :

$$\alpha_2 = \sum_{i=1}^{N} \alpha_{2i} \, v_i$$

où :

- $\alpha_{2i}$ est le CTE du matériau de la i-ème couche,
- $v_i$ est la fraction volumique du matériau de la i-ème couche au sein des deuxièmes tranchées.

Avantageusement, les premier et deuxième matériaux occupent respectivement un premier volume $V_1$ et un deuxième volume $V_2$ au sein des premières et

$$V_2 = V_1 \times \frac{|\alpha_0 - \alpha_1|}{|\alpha_0 - \alpha_2|}.$$

deuxièmes tranchées, et vérifiant

Ainsi, de tels volumes de remplissage permet-

7      EP 3 391 407 B1      8

tent d'améliorer la compensation de la courbure d'arc.

Avantageusement, les premières et deuxièmes tranchées présentent respectivement un premier facteur de forme $\Phi_1$ et un deuxième facteur de forme $\Phi_2$, définis comme le rapport entre la largeur et la profondeur des tranchées correspondantes ; et vérifiant $\Phi_2 = \Phi_1 \pm 20\%$, de préférence $\Phi_2 = \Phi_1 \pm 15\%$, plus préférentiellement $\Phi_2 = \Phi_1 \pm 10\%$.

Ainsi, de tels facteurs de forme permettent d'améliorer la compensation de la courbure d'arc.

Avantageusement, les premières tranchées sont revêtues d'une couche diélectrique intercalée entre le matériau de la tranche et le premier matériau ; et les deuxièmes tranchées sont de préférence revêtues d'une couche diélectrique intercalée entre le matériau de la tranche et le deuxième matériau.

Ainsi, de telles couches diélectriques permettent d'isoler électriquement les premières et deuxièmes tranchées de la tranche.

Avantageusement, le premier matériau affleure la première surface ; et de préférence le deuxième matériau affleure la seconde surface.

Ainsi, la présence du premier matériau est évitée hors des premières tranchées, notamment à la première surface de la tranche, dans des zones actives pour de futurs composants.

**Brève description des dessins**

D'autres caractéristiques et avantages apparaîtront dans la description qui va suivre de différents modes de réalisation de l'invention, donnés à titre d'exemples non limitatifs, en référence aux dessins annexés dans lesquels :

- la figure 1 (déjà commentée) est une vue schématique en coupe d'une tranche subissant une courbure d'arc (« *bow* ») ;
- la figure 2 (déjà commentée) est une vue schématique en coupe d'une tranche subissant un voilage (« *warp* ») ;
- les figures 3 à 5 sont des vues schématiques en coupe illustrant des étapes d'un procédé selon l'invention.

**Exposé détaillé des modes de réalisation**

Pour les différents modes de réalisation, les caractéristiques techniques décrites ci-après sont à considérer isolément ou selon toute combinaison techniquement possible ; les mêmes références sont utilisées pour des éléments identiques ou assurant la même fonction, par souci de simplification de la description.

Définitions

Par « tranche », on entend :

- une partie découpée d'un lingot d'un matériau semi-conducteur, classiquement un disque, utilisé comme matériau de base pour former des composants,
- ou plus généralement un substrat d'un matériau (e.g. une céramique, un verre, le saphir), de préférence autoporté.

Par « semi-conducteur », on entend que le matériau présente une conductivité électrique à 300 K comprise entre $10^{-8}$ S/cm et $10^3$ S/cm.

Par « diélectrique », on entend que le matériau présente une conductivité électrique à 300 K inférieure à $10^{-8}$ S/cm.

Par « longitudinal(e) », on entend une direction perpendiculaire à la normale aux première et seconde surfaces de la tranche.

Le procédé illustré aux figures 1 à 3 est un procédé de compensation d'une courbure d'arc générée dans une tranche 1 d'un matériau, la tranche 1 comportant des première et seconde surfaces 10, 11 opposées, le matériau de la tranche 1 possédant un coefficient de dilatation thermique, dit CTE et noté $\alpha_0$ ; le procédé comportant les étapes :

> a) former un ensemble de premières tranchées 100a, 100b à la première surface 10 de la tranche 1 ;
> b) former un ensemble de deuxièmes tranchées 110 à la seconde surface 11 de la tranche 1, au moins partiellement en regard des premières tranchées 100a, 100b ;
> c) remplir les premières tranchées 100a, 100b d'un premier matériau $M_1$ possédant un CTE $\alpha_1$ ;
> d) remplir les deuxièmes tranchées 110 d'un deuxième matériau $M_2$ possédant un CTE $\alpha_2$, et vérifiant $\alpha_2 > \alpha_0$ ou $\alpha_2 < \alpha_0$ selon que le premier matériau $M_1$ vérifie $\alpha_1 > \alpha_0$ ou $\alpha_1 < \alpha_0$.

Tranche

Le matériau de la tranche 1 est préférentiellement sélectionné dans le groupe comportant un matériau semi-conducteur, une céramique, un verre, le saphir. Le matériau semi-conducteur de la tranche 1 est préférentiellement à base de silicium. A titre d'exemple, $\alpha_0$ (Si)=$2,5 \times 10^{-6}$ K$^{-1}$ à 300 K. Le silicium est avantageusement dopé de sorte que la tranche 1 présente une résistivité inférieure à 1 ohm.cm, préférentiellement inférieure à $10^{-2}$ ohm.cm.

Premières tranchées

Les premières tranchées 100a, 100b comportent préférentiellement des premières tranchées 100a primaires et des premières tranchées 100b secondaires. L'étape a) est avantageusement exécutée de sorte que les premières tranchées 100a primaires dessinent un chemin de découpe de la tranche 1. Les premières tranchées 100b secondaires sont avantageusement agen-

5

cées pour isoler électriquement des composants électroniques 4 à la première surface 10 de la tranche 1. Les premières tranchées 100a primaires sont plus profondes que les premières tranchées 100b secondaires. Comme illustré à la figure 3, les premières tranchées 100a, 100b sont formées lors de l'étape a) préférentiellement en déposant préalablement un masque dur 2 et une résine photosensible 3 à la première surface 10 de la tranche 1. Puis les premières tranchées 100a, 100b sont formées lors de l'étape a) par des étapes de photolithographie et de gravure.

Le premier matériau $M_1$ occupe un premier volume $V_1$ au sein des premières tranchées 100a, 100b à l'issue de l'étape c). Le procédé comporte avantageusement une étape $c_1$) consistant à aplanir le premier matériau $M_1$ de manière à affleurer la première surface 10 après l'étape c). L'étape $c_1$) est préférentiellement exécutée par un polissage mécano-chimique.

Le premier matériau $M_1$ est avantageusement sélectionné dans le groupe comportant le silicium polycristallin, un polyimide, un polyépoxyde, un acrylique, un oxyde, un nitrure, un verre.

Les premières tranchées 100a, 100b présentent un premier facteur de forme $\Phi_1$ lors de l'étape a). $\Phi_1$ est défini comme le rapport entre la largeur $l_1$ et la profondeur $H_1$ des premières tranchées 100a, 100b correspondantes.

Le procédé comporte avantageusement une étape $a_1$) consistant à revêtir les premières tranchées 100a, 100b d'une couche diélectrique 101 avant l'étape c). La couche diélectrique 101 est préférentiellement une couche d'oxyde, telle que du $SiO_2$ lorsque le matériau semi-conducteur de la tranche 1 est à base de Si. La couche d'oxyde est préférentiellement un oxyde thermique. Le premier matériau $M_1$ peut être identique à la couche diélectrique 101. A titre d'exemple, a $(SiO_2)=0,6 \times 10^{-6}\,K^{-1}$ à 300 K. Cependant, pour certaines applications, les premières tranchées 100a, 100b présentent une profondeur $H_1$ comprise entre 50 μm et 100 μm ; leur remplissage par un oxyde thermique conduirait à un temps d'opération très long, et à une mauvaise tenue mécanique en température. Il peut donc être préférable d'utiliser un premier matériau $M_1$ différent de $SiO_2$, tel que du silicium polycristallin pour certaines applications.

Deuxièmes tranchées

Les deuxièmes tranchées 110 sont formées lors de l'étape b) préférentiellement en déposant préalablement un masque dur 2 et une résine photosensible 3 à la seconde surface 11 de la tranche 1. Puis les deuxièmes tranchées 110 sont formées lors de l'étape b) par des étapes de photolithographie et de gravure.

L'étape b) est exécutée de sorte que les deuxièmes tranchées 110 sont totalement, en regard des premières tranchées 100a primaires, comme illustré à la figure 4. L'étape b) peut être également exécutée de sorte que les deuxièmes tranchées 110 sont au moins partiellement, de préférence totalement, en regard des premières tranchées 100a primaires et des premières tranchées 100b secondaires. La mise en œuvre des étapes a) et b) est particulièrement simplifiée lorsque les deuxièmes tranchées 110 font face aux premières tranchées 100a primaires, voire aux premières tranchées 100a primaires et aux premières tranchées 100b secondaires, dans la mesure où il est possible d'utiliser un même alignement de masque pour leur formation. La tranche 1 présente un plan médian longitudinal. Les deuxièmes tranchées 110 et les premières tranchées 100a primaires sont avantageusement symétriques relativement au plan médian longitudinal. Les deuxièmes tranchées 110 ainsi que les premières tranchées 100a primaires et les premières tranchées 100b secondaires sont avantageusement symétriques relativement au plan médian longitudinal.

Le deuxième matériau $M_2$ occupe un deuxième volume $V_2$ au sein des deuxièmes tranchées 110 à l'issue de l'étape d). Le procédé comporte avantageusement une étape $d_1$) consistant à aplanir le deuxième matériau $M_2$ de manière à affleurer la seconde surface 11 après l'étape d). L'étape $d_1$) est préférentiellement exécutée par un polissage mécano-chimique.

Le deuxième matériau $M_2$ est avantageusement sélectionné dans le groupe comportant le silicium polycristallin, un polyimide, un polyépoxyde, un acrylique, un oxyde, un nitrure, un verre. Le deuxième matériau $M_2$ est avantageusement identique au premier matériau $M_1$ de sorte que les étapes c) et d) peuvent être concomitantes.

L'étape d) est avantageusement exécutée de sorte que $V_2 = V_1 \times \frac{|\alpha_0 - \alpha_1|}{|\alpha_0 - \alpha_2|}$. Le calcul peut être réalisé à l'aide de la formule de Stoney.

Les deuxièmes tranchées 110 présentent un premier facteur de forme $\Phi_2$ lors de l'étapes b). $\Phi_2$ est défini comme le rapport entre la largeur $l_2$ et la profondeur $H_2$ des deuxièmes tranchées 110 correspondantes. L'étape b) est avantageusement exécutée de sorte que $\Phi_2 = \Phi_1 \pm 20\%$, de préférence $\Phi_2 = \Phi_1 \pm 15\%$, plus préférentiellement $\Phi_2 = \Phi_1 \pm 10\%$.

Le procédé comporte avantageusement une étape $b_1$) consistant à revêtir les deuxièmes tranchées 110 d'une couche diélectrique 111 avant l'étape d). La couche diélectrique 111 est préférentiellement une couche d'oxyde telle que du $SiO_2$ lorsque le matériau semi-conducteur de la tranche 1 est à base de Si. La couche d'oxyde est préférentiellement un oxyde thermique. Lorsque les couches diélectriques 101, 111 sont des oxydes thermiques, les étapes $a_1$) et $b_1$) sont avantageusement concomitantes. Le deuxième matériau $M_2$ peut être identique à la couche diélectrique 111. A titre d'exemple, a $(SiO_2)=0,6 \times 10^{-6}\,K^{-1}$ à 300 K. Cependant, pour certaines applications, les deuxièmes tranchées 110 présentent une profondeur $H_2$ comprise entre 50 μm et 100 μm ; leur remplissage par un oxyde thermique conduirait à un temps d'opération très long, et à une mauvaise tenue mécanique en température. Il peut donc être préférable d'utiliser un deuxième matériau $M_2$ différent de $SiO_2$, tel que du silicium polycristallin pour certaines applications.

Des simulations permettent de constater que les paramètres $(\alpha_2, V_2, \Phi_2)$ déterminés selon l'invention optimisent la compensation de la courbure d'arc.

Exemple d'application

A l'issue du procédé selon l'invention, il est possible de former des composants 4, tels que des diodes électroluminescentes, à la première surface 10 de la tranche 1. Les diodes électroluminescentes peuvent être formées par épitaxie de GaN, à une température de 1050°C. Les diodes électroluminescentes sont ensuite préférentiellement revêtues d'un substrat de protection (ou substrat support dit poignée) assemblé à la première surface 10 de la tranche 1 par collage. La poignée peut être temporaire ou permanente. Il en résulte un collage temporaire ou permanent. Le substrat de protection est réalisé dans un matériau préférentiellement sélectionné dans le groupe comportant un verre, le silicium, le quartz, le saphir. Plus généralement, tout substrat rigide, transparent dans le spectre d'émission des diodes électroluminescentes, peut convenir en tant que substrat de protection. Puis la deuxième surface 11 de la tranche 1 est amincie jusqu'à atteindre les première tranchées 110. La deuxième surface 11 amincie sera ensuite métallisée pour les reprises de contact.

Bien entendu, d'autres applications sont envisageables telles que :

- des applications en microfluidique lorsque le matériau de la tranche 1 est un verre,
- des applications en microélectronique hybride lorsque le matériau de la tranche 1 est une céramique.

**Revendications**

1. Procédé de compensation d'une courbure d'arc ($B_w$) générée dans une tranche (1) d'un matériau, la tranche (1) comportant des première et seconde surfaces (10, 11) opposées, le matériau de la tranche (1) possédant un coefficient de dilatation thermique, dit CTE et noté ao ; le procédé comportant les étapes :

   a) former un ensemble de premières tranchées (100a, 100b) à la première surface (10) de la tranche (1), des composants électronique devant être formés sur la première surface (10) ;
   b) former un ensemble de deuxièmes tranchées (110) à la seconde surface (11) de la tranche (1), au moins partiellement en regard des premières tranchées (100a, 100b) ;
   c) remplir les premières tranchées (100a, 100b) d'un premier matériau ($M_1$) possédant un CTE $\alpha_1$ ;

   d) remplir les deuxièmes tranchées (110) d'un deuxième matériau ($M_2$) possédant un CTE $\alpha_2$, et vérifiant $\alpha_2 > \alpha_0$ lorsque le premier matériau ($M_1$) vérifie $\alpha_1 > \alpha_0$ ou $\alpha_2 < \alpha_0$ lorsque le premier matériau ($M_1$) vérifie $\alpha_1 < \alpha_0$
   procédé **caractérisé en ce que** l'étape a) est exécutée de sorte que les premières tranchées (100a) dessinent un chemin de découpe de la tranche (1), et l'étape b) est exécutée de sorte que les deuxièmes tranchées (110) sont totalement en regard des premières tranchées (100a).

2. Procédé selon la revendication 1, dans lequel les premier et deuxième matériaux ($M_1$, $M_2$) occupent respectivement un premier volume $V_1$ et un deuxième volume $V_2$ au sein des premières et deuxièmes tranchées (100a, 100b; 110) à l'issue des étapes c) et d) ; et l'étape d) est exécutée de sorte que

$$V_2 = V_1 \times \frac{|\alpha_0 - \alpha_1|}{|\alpha_0 - \alpha_2|}$$ et dans lequel les premières et deuxièmes tranchées (100a, 100b; 110) présentent respectivement un premier facteur de forme $\Phi_1$ et un deuxième facteur de forme $\Phi_2$ lors des étapes a) et b), définis comme le rapport entre la largeur ($l_1$, $l_2$) et la profondeur ($H_1$, $H_2$) des tranchées (100a, 100b ; 110) correspondantes ; et l'étape b) est exécutée de sorte que $\Phi_2 = \Phi_1 \pm 20\%$, de préférence $\Phi_2 = \Phi_1 \pm 15\%$, plus préférentiellement $\Phi_2 = \Phi_1 \pm 10\%$.

3. Procédé selon l'une des revendications 1 et 2, comportant une étape $a_1$) consistant à revêtir les premières tranchées (100a, 100b) d'une couche diélectrique (101) avant l'étape c), la couche diélectrique (101) étant préférentiellement une couche d'oxyde.

4. Procédé selon l'une des revendications 1 à 3, comportant une étape $b_1$) consistant à revêtir les deuxièmes tranchées (110) d'une couche diélectrique (111) avant l'étape d), la couche diélectrique (111) étant préférentiellement une couche d'oxyde.

5. Procédé selon la revendication 4 en combinaison avec la revendication 3, dans lequel les étapes $a_1$) et $b_1$) sont concomitantes.

6. Procédé selon l'une des revendications 1 à 5, dans lequel l'étape d) est exécutée de sorte que le deuxième matériau ($M_2$) est identique au premier matériau ($M_1$), les étapes c) et d) étant de préférence concomitantes.

7. Procédé selon l'une des revendications 1 à 6, comportant :

- une étape $c_1$) consistant à aplanir le premier matériau ($M_1$) de manière à affleurer la première surface (10) après l'étape c) ; et de préférence
- une étape $d_1$) consistant à aplanir le deuxième matériau ($M_2$) de manière à affleurer la seconde surface (11) après l'étape d).

**8.** Procédé selon l'une des revendications 1 à 7, dans lequel les premier et deuxième matériaux ($M_1$, $M_2$) sont sélectionnés dans le groupe comportant le silicium polycristallin, un polyimide, un polyépoxyde, un acrylique, un oxyde, un nitrure, un verre.

**9.** Procédé selon l'une des revendications 1 à 8, dans lequel le matériau de la tranche (1) est sélectionné dans le groupe comportant un matériau semi-conducteur, une céramique, un verre, le saphir; le matériau semi-conducteur étant de préférence à base de silicium.

**10.** Procédé selon l'une des revendications 1 à 9, dans lequel l'ensemble de premières tranchées (100a, 100b) comporte des premières tranchées (100b) secondaires et des premières tranchées (100a) primaires plus profondes que les premières tranchées (100b) secondaires et dans lequel les premières tranchées (100a) primaires dessinent le chemin de découpe de la tranche (1) et les premières tranchées (100b) secondaires sont agencées pour isoler électriquement les composants électroniques (4) à la première surface (10) de la tranche (1).

**11.** Structure de compensation d'une courbure d'arc ($B_w$), comportant :

- une tranche (1) d'un matériau, comprenant des première et seconde surfaces (10, 11) opposées, le matériau de la tranche (1) possédant un coefficient de dilatation thermique, dit CTE et noté $\alpha_0$ ;
- un ensemble de premières tranchées (100a, 100b) formées à la première surface (10), et remplies d'un premier matériau ($M_1$) possédant un CTE $\alpha_1$ ;
- un ensemble de deuxièmes tranchées (110) formées à la seconde surface (11), au moins partiellement en regard des premières tranchées (100a, 100b), et remplies d'un deuxième matériau ($M_2$) possédant un CTE $\alpha_2$, et vérifiant $\alpha_2 > \alpha_0$ lorsque le premier matériau ($M_1$) vérifie $\alpha_1 > \alpha_0$ ou $\alpha_2 < \alpha_0$ lorsque le premier matériau ($M_1$) vérifie $\alpha_1 < \alpha_0$
structure **caractérisée en ce que** les premières tranchées (100a) dessinent un chemin de découpe de la tranche (1), et les deuxièmes tranchées (110) sont totalement en regard des premières tranchées (100a).

**12.** Structure selon la revendication 11, dans laquelle les premier et deuxième matériaux ($M_1$, $M_2$) occupent respectivement un premier volume $V_1$ et un deuxième volume $V_2$ au sein des premières et deuxièmes tranchées (100a, 100b ; 110), et vérifiant

$$V_2 = V_1 \times \frac{|\alpha_0 - \alpha_1|}{|\alpha_0 - \alpha_2|}$$ et dans laquelle les premières et deuxièmes tranchées (100a, 100b ; 110) présentent respectivement un premier facteur de forme $\Phi_1$ et un deuxième facteur de forme $\Phi_2$, définis comme le rapport entre la largeur ($l_1$, $l_2$) et la profondeur ($H_1$, $H_2$) des tranchées (100a, 100b ; 110) correspondantes ; et vérifiant $\Phi_2 = \Phi_1 \pm 20\%$, de préférence $\Phi_2 = \Phi_1 \pm 15\%$, plus préférentiellement $\Phi_2 = \Phi_1 \pm 10\%$.

**13.** Structure selon l'une des revendications 11 et 12, dans laquelle les premières tranchées (100a, 100b) sont revêtues d'une couche diélectrique (101) intercalée entre le matériau de la tranche (1) et le premier matériau ($M_1$) ; et les deuxièmes tranchées (110) sont de préférence revêtues d'une couche diélectrique (111) intercalée entre le matériau de la tranche (1) et le deuxième matériau ($M_2$).

**14.** Structure selon l'une des revendications 11 à 13, dans laquelle le premier matériau ($M_1$) affleure la première surface (10) ; et de préférence le deuxième matériau ($M_2$) affleure la seconde surface (11).

**15.** Structure selon l'une des revendications 11 à 14, dans laquelle l'ensemble de premières tranchées (100a, 100b) comporte des premières tranchées (100b) secondaires et des premières tranchées (100a) primaires plus profondes que les premières tranchées (100b) secondaires et dans lequel les premières tranchées (100a) primaires dessinent le chemin de découpe de la tranche (1) et les premières tranchées (100b) secondaires sont agencées pour isoler électriquement les composants électroniques (4) à la première surface (10) de la tranche (1).

**Patentansprüche**

**1.** Verfahren zum Kompensieren einer Bogenkrümmung ($B_w$), die in einem aus einem Material bestehenden Wafer (1) entsteht, wobei der Wafer (1) erste und zweite gegenüberliegende Oberflächen (10, 11) umfasst und das Material des Wafers (1) einen Wärmeausdehnungskoeffizienten besitzt, der als CTE bezeichnet wird und den Wert $\alpha_0$ aufweist, wobei das Verfahren folgende Schritte umfasst:

a) Bilden einer Anordnung von ersten Gräben (100a, 100b) an der ersten Oberfläche (10) des Wafers (1), wobei elektronische Bauteile an der ersten Oberfläche (10) vorgesehen sind;

b) Bilden einer Anordnung von zweiten Gräben (110) an der zweiten Oberfläche (11) des Wafers (1), die zumindest teilweise den ersten Gräben (100a, 100b) gegenüber liegen;

c) Ausfüllen der ersten Gräben (100a, 100b) mit einem ersten Material ($M_1$), das einen CTE von $\alpha_1$ besitzt;

d) Ausfüllen der zweiten Gräben (110) mit einem zweiten Material ($M_2$), das einen CTE von $\alpha_2$ besitzt und $\alpha_2 > \alpha_0$ erfüllt, wenn das erste Material ($M_1$) $\alpha_1 > \alpha_0$ erfüllt, oder $\alpha_2 < \alpha_0$ erfüllt, wenn das erste Material ($M_1$) $\alpha_1 < \alpha_0$ erfüllt, wobei das Verfahren **dadurch gekennzeichnet ist, dass** der Schritt a) derart ausgeführt wird, dass die ersten Gräben (100a) einen Schnittverlauf des Wafers (1) vorzeichnen, und der Schritt b) derart ausgeführt wird, dass die zweiten Gräben (110) gänzlich gegenüber den ersten Gräben (100a) liegen.

2. Verfahren nach Anspruch 1, wobei die ersten und zweiten Materialien ($M_1$, $M_2$) am Ende der Schritte c) und d) jeweils ein erstes Volumen $V_1$ und ein zweites Volumen $V_2$ innerhalb der ersten und zweiten Gräben (100a, 100b; 110) einnehmen; und der Schritt d) derart ausgeführt wird, dass

$$V_2 = V_1 \times \frac{|\alpha_0 - \alpha_1|}{|\alpha_0 - \alpha_2|},$$

und wobei die ersten und zweiten Gräben (100a, 100b; 110) in den Schritten a) und b) jeweils einen ersten Formfaktor $\Phi_1$ und einen zweiten Formfaktor $\Phi_2$ aufweisen, die als das Verhältnis zwischen der Breite ($l_1$, $l_2$) und der Tiefe ($H_1$, $H_2$) der entsprechenden Gräben (100a, 100b; 110) definiert sind; und der Schritt b) derart ausgeführt wird, dass $\Phi_2 = \Phi_1 \pm 20$ %, bevorzugt $\Phi_2 = \Phi_1 \pm 15$ %, weiter bevorzugt $\Phi_2 = \Phi_1 \pm 10$ %.

3. Verfahren nach einem der Ansprüche 1 und 2, umfassend einen Schritt $a_1$), der darin besteht, die ersten Gräben (100a, 100b) vor dem Schritt c) mit einer dielektrischen Schicht (101) zu beschichten, wobei die dielektrische Schicht (101) bevorzugt eine Oxidschicht ist.

4. Verfahren nach einem der Ansprüche 1 bis 3, umfassend einen Schritt $b_1$), der darin besteht, die zweiten Gräben (110) vor dem Schritt d) mit einer dielektrischen Schicht (111) zu beschichten, wobei die dielektrische Schicht (111) bevorzugt eine Oxidschicht ist.

5. Verfahren nach Anspruch 4 kombiniert mit Anspruch 3, wobei die Schritte $a_1$) und $b_1$) gleichzeitig sind.

6. Verfahren nach einem der Ansprüche 1 bis 5, wobei der Schritt d) derart ausgeführt wird, dass das zweite Material ($M_2$) mit dem ersten Material ($M_1$) identisch ist, wobei die Schritte c) und d) bevorzugt gleichzeitig sind.

7. Verfahren nach einem der Ansprüche 1 bis 6, umfassend:

- einen Schritt $c_1$), der darin besteht, das erste Material ($M_1$) nach dem Schritt c) derart zu ebnen, dass es mit der ersten Oberfläche (10) bündig ist; und bevorzugt
- einen Schritt $d_1$), der darin besteht, das zweite Material ($M_2$) nach dem Schritt d) derart zu ebnen, dass es mit der zweiten Oberfläche (11) bündig ist.

8. Verfahren nach einem der Ansprüche 1 bis 7, wobei die ersten und zweiten Materialien ($M_1$, $M_2$) aus der Gruppe ausgewählt werden, die polykristallines Silizium, ein Polyimid, ein Polyepoxid, ein Acryl, ein Oxid, ein Nitrid, eine Glasart umfasst.

9. Verfahren nach einem der Ansprüche 1 bis 8, wobei das Material des Wafers (1) aus der Gruppe ausgewählt wird, die ein Halbleitermaterial, eine Keramikart, eine Glasart, Saphir umfasst; wobei das Halbleitermaterial bevorzugt auf Silizium basiert.

10. Verfahren nach einem der Ansprüche 1 bis 9, wobei die Anordnung von ersten Gräben (100a, 100b) sekundäre erste Gräben (100b) und primäre erste Gräben (100a), die tiefer als die sekundären ersten Gräben (100b) sind, umfasst, und wobei die primären ersten Gräben (100a) den Schnittverlauf des Wafers (1) vorzeichnen und die sekundären ersten Gräben (100b) angeordnet sind, um die elektronischen Bauteile (4) an der ersten Oberfläche (10) des Wafers (1) elektrisch zu isolieren.

11. Struktur zum Kompensieren einer Bogenkrümmung ($B_w$), umfassend:

- einen aus einem Material bestehenden Wafer (1), der gegenüberliegende erste und zweite Oberflächen (10, 11) umfasst, wobei das Material des Wafers (1) einen Wärmeausdehnungskoeffizienten besitzt, der als CTE bezeichnet wird und den Wert $\alpha_0$ aufweist;
- eine Anordnung von ersten Gräben (100a, 100b), die an der ersten Oberfläche (10) gebildet sind und mit einem ersten Material ($M_1$) ausgefüllt sind, das einen CTE von $\alpha_1$ aufweist;
- eine Anordnung von zweiten Gräben (110), die an der zweiten Oberfläche (11) zumindest teilweise gegenüber den ersten Gräben (100a, 100b) liegend gebildet und mit einem zweiten Material ($M_2$) ausgefüllt sind, das einen CTE von $\alpha_2$ besitzt und $\alpha_2 > \alpha_0$ erfüllt, wenn das erste Material ($M_1$) $\alpha_1 > \alpha_0$ erfüllt, oder $\alpha_2 < \alpha_0$ erfüllt, wenn das erste Material ($M_1$) $\alpha_1 < \alpha_0$ erfüllt, wobei die Struktur **dadurch gekennzeichnet ist, dass** die ersten Gräben (100a) einen Schnittverlauf des Wafers (1) vorzeichnen und sich die zweiten Gräben (110) gänzlich gegenüber den ersten Gräben (100a) befinden.

**12.** Struktur nach Anspruch 11, wobei die ersten und zweiten Materialien ($M_1$, $M_2$) jeweils ein erstes Volumen $V_1$ und ein zweites Volumen $V_2$ innerhalb der ersten und zweiten Gräben (100a, 100b; 110) einnehmen und

$$V_2 = V_1 \times \frac{|\alpha_0 - \alpha_1|}{|\alpha_0 - \alpha_2|}$$

erfüllen, und wobei die ersten und zweiten Gräben (100a, 100b; 110) jeweils einen ersten Formfaktor $\Phi_1$ und einen zweiten Formfaktor $\Phi_2$ aufweisen, die als das Verhältnis zwischen der Breite ($l_1$, $l_2$) und der Tiefe ($H_1$, $H_2$) der entsprechenden Gräben (100a, 100b; 110) definiert sind; und $\Phi_2 = \Phi_1 \pm 20$ %, bevorzugt $\Phi_2 = \Phi_1 \pm 15$ %, weiter bevorzugt $\Phi_2 = \Phi_1 \pm 10$ % erfüllen.

**13.** Struktur nach einem der Ansprüche 11 und 12, wobei die ersten Gräben (100a, 100b) mit einer dielektrischen Schicht (101) beschichtet sind, die zwischen dem Material des Wafers (1) und dem ersten Material ($M_1$) eingeschoben ist; und die zweiten Gräben (110) bevorzugt mit einer dielektrischen Schicht (111) beschichtet sind, die zwischen dem Material des Wafers (1) und dem zweiten Material ($M_2$) eingeschoben ist.

**14.** Struktur nach einem der Ansprüche 11 bis 13, wobei das erste Material ($M_1$) mit der ersten Oberfläche (10) bündig ist; und das zweite Material ($M_2$) bevorzugt mit der zweiten Oberfläche (11) bündig ist.

**15.** Struktur nach einem der Ansprüche 11 bis 14, wobei die Anordnung von ersten Gräben (100a, 100b) sekundäre erste Gräben (100b) und primäre erste Gräben (100a), die tiefer als die sekundären ersten Gräben (100b) sind, umfasst, und wobei die primären ersten Gräben (100a) den Schnittverlauf des Wafers (1) vorzeichnen und die sekundären ersten Gräben (100b) angeordnet sind, um die elektronischen Bauteile (4) an der ersten Oberfläche (10) des Wafers (1) elektrisch zu isolieren.

**Claims**

**1.** Method for performing compensation of a bow ($B_w$),

generated in a wafer (1) made from a material, the wafer (1) comprising opposite first and second surfaces (10, 11), the material of the wafer (1) having a coefficient of thermal expansion called CTE and noted $\alpha_0$, the method comprising the steps :

a) forming a set of first trenches (100a, 100b) on the first surface (10) of the wafer (1), electronic components having to be formed on the first surface 10);
b) forming a set of second trenches (110) on the second surface (11) of the wafer (1), at least partially facing the first trenches (100a, 100b);
c) filling the first trenches (100a, 100b) with a first material ($M_1$) having a CTE $\alpha_1$;
d) filling the second trenches (110) with a second material ($M_2$) having a CTE $\alpha_2$, and verifying $\alpha_2 > \alpha_0$ when the first material ($M_1$) verifies $\alpha_1 > \alpha_0$ or $\alpha_2 < \alpha_0$ when the first material ($M_1$) verifies $\alpha_1 < \alpha_0$

method **characterised in that** step a) is executed in such a way that the first trenches (100a) define a cutting path of the wafer (1), and step b) is executed in such a way that the second trenches (110) are totally facing the first trenches (100a).

**2.** Method according to claim 1, wherein the first and second materials ($M_1$, $M_2$) respectively occupy a first volume $V_1$ and a second volume $V_2$ inside the first and second trenches (100a, 100b; 110) on completion of steps c) and d); and step d) is executed in such a way that

$$V_2 = V_1 \times \frac{|\alpha_0 - \alpha_1|}{|\alpha_0 - \alpha_2|},$$

and wherein the first and second trenches (100a, 100b; 110) respectively present a first form factor $\Phi_1$ and a second form factor $\Phi_2$ in steps a) and b), defined as being the ratio between the width ($l_1$, $l_2$) and depth ($H_1$, $H_2$) of the corresponding trenches (100a, 100b; 110); and step b) is executed in such a way that $\Phi_2 = \Phi_1 \pm 20\%$, preferably $\Phi_2 = \Phi_1 \pm 15\%$, more preferentially $\Phi_2 = \Phi_1 \pm 10\%$.

**3.** Method according to one of claims 1 and 2, comprising a step $a_1$) consisting in coating the first trenches (100a, 100b) with a dielectric layer (101) before step c), the dielectric layer (101) preferentially being an oxide layer.

**4.** Method according to one of claims 1 to 3, comprising a step $b_1$) consisting in coating the second trenches (110) with a dielectric layer (111) before step d), the dielectric layer (111) preferentially being an oxide layer.

**5.** Method according to claim 4 in combination with claim 3, wherein steps $a_1$) and $b_1$) are concomitant.

6. Method according to one of claims 1 to 5, wherein step d) is executed in such a way that the second material ($M_2$) is identical to the first material ($M_1$), steps c) and d) preferably being concomitant.

7. Method according to one of claims 1 to 6, comprising:

    - a step $c_1$) consisting in planarizing the first material ($M_1$) so as to be flush with the first surface (10) after step c); and preferably
    - a step $d_1$) consisting in planarizing the second material ($M_2$) so as to be flush with the second surface (11) after step d).

8. Method according to one of claims 1 to 7, wherein the first and second materials ($M_1$, $M_2$) are selected from the group comprising polycrystalline silicon, a polyimide, a polyepoxide, an acrylic, an oxide, a nitride, and a glass.

9. Method according to one of claims 1 to 8, wherein the material of the wafer (1) is selected from the group comprising a semiconductor material, a ceramic, a glass, and sapphire, the semiconductor material preferably being silicon-based.

10. Method according to one of claims 1 to 9, wherein the set of first trenches (100a, 100b) comprises secondary first trenches (100b) and primary first trenches (100a) that are deeper than the secondary first trenches (100b), and wherein the primary first trenches (100a) define the cutting path of the wafer (1) and the secondary first trenches (100b) are arranged to electrically insulate the electronic components (4) on the first surface (10) of the wafer (1).

11. Structure for performing compensation of a bow ($B_w$), comprising:

    - a wafer (1) made from a material, comprising opposite first and second surfaces (10, 11), the material of the wafer (1) having a coefficient of thermal expansion, called CTE and noted $\alpha_0$;
    - a set of first trenches (100a, 100b) formed on the first surface (10) and filled with a first material ($M_1$) having a CTE $\alpha_1$;
    - a set of second trenches (110) formed on the second surface (11), at least partially facing the first trenches (100a, 100b), and filled with a second material ($M_2$) having a CTE $\alpha_2$, and verifying $\alpha_2 > \alpha_0$ when the first material ($M_1$) verifies $\alpha_1 > \alpha_0$ or $\alpha_2 < \alpha_0$ when the first material ($M_1$) verifies $\alpha_1 < \alpha_0$
    structure **characterised in that** the first trenches (100a) define a cutting path of the wafer (1) and the second trenches (110) are totally facing the first trenches (100a).

12. Structure according to claim 11, wherein the first and second materials ($M_1$, $M_2$) respectively occupy a first volume $V_1$ and a second volume $V_2$ inside the first and second trenches (100a, 100b; 110), and verifying

$$V_2 = V_1 \times \frac{|\alpha_0 - \alpha_1|}{|\alpha_0 - \alpha_2|}$$

and wherein the first and second trenches (100a, 100b; 110) respectively present a first form factor $\Phi_1$ and a second form factor $\Phi_2$ defined as being the ratio between the width ($l_1$, $l_2$) and depth ($H_1$, $H_2$) of the corresponding trenches (100a, 100b; 110) and verifying $\Phi_2 = \Phi_1 \pm 20\%$, preferably $\Phi_2 = \Phi_1 \pm 15\%$, more preferentially $\Phi_2 = \Phi_1 \pm 10\%$.

13. Structure according to one of claims 11 and 12, wherein the first trenches (100a, 100b) are coated with a dielectric layer (101) inserted between the material of the wafer (1) and the first material ($M_1$), and the second trenches (110) are preferably coated with a dielectric layer (111) inserted between the material of the wafer (1) and the second material ($M_2$).

14. Structure according to one of claims 11 to 13, wherein the first material ($M_1$) is flush with the first surface (10), and preferably the second material ($M_2$) is flush with the second surface (11).

15. Structure according to one of claims 11 to 14, wherein the set of first trenches (100a, 100b) comprises secondary first trenches (100b) and primary first trenches (100a) that are deeper than the secondary first trenches (100b), and wherein the primary first trenches (100a) define the cutting path of the wafer (1) and the secondary first trenches (100b) are arranged to electrically insulate the electronic components (4) on the first surface (10) of the wafer (1).

*Fig. 1*

*Fig. 2*

*Fig. 3*

*Fig. 4*

*Fig. 5*

## RÉFÉRENCES CITÉES DANS LA DESCRIPTION

**Documents brevets cités dans la description**

- JP 2002134451 B
- JP 56140631 B
- WO 2010102686 A